# EUROPEAN PATENT APPLICATION

(11) **EP 4 645 377 A1**
(43) Date of publication of application: **05.11.2025**
(21) Application number: 23909842.9
(22) Date of filing: 24.11.2023
(51) Int. Cl.: H01L 21/677, H01L 21/683

(54) **TRANSFER DEVICE**

(30) Priority: 27.12.2022 CN 202211679474
(71) Applicant: Yinguan Semiconductor Technology Co., Ltd., Shanghai 201206 (CN)
(72) Inventor: GAO, Yuanzhen, Shanghai 201206 (CN); YUAN, Jiaxin, Shanghai 201206 (CN); JIANG, Xuchu, Shanghai 201206 (CN); TANG, Yanwen, Shanghai 201206 (CN); WU, Huoliang, Shanghai 201206 (CN)
(74) Representative: Novagraaf Technologies
(86) International application number: PCT/CN2023/134130
(87) International publication number: WO 2024/139911

(57) **Abstract**

Provided in the present application is a transfer device, including a base, a lifting and lowering component and a rotating component. The lifting and lowering component includes a supporting component and a vertical driving component for driving the supporting component to perform lifting and lowering motion, the rotating component includes a rotation driving component and a carrying device located above the lifting and lowering component, and the rotation driving component can drive the supporting component and the carrying device to perform synchronous rotational motion, wherein a rotation decoupling component is disposed between the vertical driving component and the supporting component to keep the vertical driving component stationary when the supporting component performs rotational motion. In the transfer device of the present application, the rotational motion of the supporting component is decoupled from the vertical motion of a rotor to solve the problems of winding and twisting of gas paths and cables, thereby improving the system reliability, and prolonging the service life of the device. In addition, supporting claws rotate along with the carrying device. Compared to an apparatus where supporting claws do not rotate along with the carrying device, the vertical motion stroke of the thickness of one carrying device can be shortened, thereby solving the problem of excessively long transfer stroke, and improving the transfer efficiency.

## Description

The present application claims priority to Patent Application No. 2022116794744, entitled "TRANSFER DEVICE" filed with the China National Intellectual Property Administration on December 27, 2022.

### Technical Field

The present application belongs to the field of integrated circuit manufacture, and relates to a transfer device.

### Background

With the continuous increase in integration level of large-scale integrated circuit equipment, an equipped workpiece platform usually needs to have a wafer transfer function, for example, in the fields of photoetching devices and measurement devices. In order to achieve the wafer transfer function, the equipped workpiece platform needs to be provided with a wafer transfer device.

An existing wafer transfer device usually uses a motor or a cylinder to drive the vertical motion of transfer claws. When the equipped workpiece platform has the degree of freedom of rotation, the entire transfer device usually rotates synchronously along with a suction cup, which inevitably leads to the problem of winding of cables and gas pipes of the transfer device as well as the problem of reliability caused by fatigue, affecting the maintenance period, reliability and service life of the entire workpiece platform.

The patent CN205176483U provides a wafer transfer device. A lifting and lowering claw is mounted below a suction cup and driven by the suction cup to rotate synchronously, and is driven by a plurality of cylinders to perform vertical motion. The bottom of the lifting and lowering claw is spherical. The top of the cylinder is connected to a flat plate. The flat plate pushes the lifting and lowering claw to perform vertical motion. Motion decoupling is achieved through decoupling contact between a spherical surface and a flat surface. When the lifting and lowering claw moves down, the lifting and lowering claw is pulled back to the initial position by a spring. Due to the problem of gas path decoupling, the lifting and lowering claw is difficult to pass through vacuum and does not have an adsorption function, and the synchronization of the plurality of cylinders is difficult to control, which affects the safety and transfer accuracy of supporting wafers.

The patent CN103309176B provides a wafer transfer device. A supporting component is fixedly connected to a rotor structure. The rotor structure and stator structure of a voice coil motor are connected through a micro-ball guide rail to achieve vertical guidance, but respective degrees of freedom of rotation are also limited. Therefore, when the supporting component synchronously rotates along with a suction cup, the entire supporting transfer device is driven to synchronously rotate, and then, the gas paths and cables connected to the device also rotate, causing winding and twisting, thereby affecting the reliability and service life of the device.

The patent CN110032044A provides a wafer transfer device. A lifting and lowering driving unit drives a carrier to move up and down, a rotation driving unit drives the carrier to rotate and simultaneously drives the lifting and lowering driving unit to rotate, that is, the entire device synchronously rotates, and then, the gas paths and cables connected to the device also rotate, causing winding and twisting.

Therefore, how to provide a transfer device to decouple the vertical motion from rotational motion of the transfer device, avoid winding and twisting of gas pipes and cables caused by rotation, and improve the reliability and service life of the entire device has become an urgent technical problem to be solved by those skilled in the art.

### Summary

In view of the defects in the prior art mentioned above, the objective of the present application is to provide a transfer device for solving the problems of winding and twisting of cables and gas pipes of the transfer device caused by synchronous rotation of the transfer device following a suction cup in the prior art.

To achieve the above objective and other related objectives, the present application provides a transfer device, including:
a base, including a base bottom and a base side wall, wherein the base bottom and the base side wall enclose an accommodating space;
a lifting and lowering component, including a vertical driving component located at the base bottom and a supporting component located above the vertical driving component, wherein the vertical driving component includes a stator and a rotor, the stator is mounted at the base bottom, and the rotor is mounted on the stator and configured for vertical motion relative to the stator; and the supporting component performs lifting and lowering motion along with the rotor, and the upper end of the supporting component is configured with a plurality of supporting claws; and
a rotating component, including a rotation driving component located outside the supporting component and a carrying device located above the lifting and lowering component, wherein the rotating component is configured to rotate relative to the base, the rotation driving component drives the supporting component and the carrying device to perform synchronous rotational motion, and the supporting component is configured for lifting and lowering motion relative to the carrying device; and
the lifting and lowering component further includes a rotation decoupling component, wherein the rotation decoupling component is located between the vertical driving component and the supporting component, and the vertical driving component is rotationally connected with the supporting component through the rotation decoupling component, so that when the supporting component performs rotational motion, the vertical driving component does not perform rotational motion along with the supporting component.

Optionally, the rotation decoupling component includes a double-ring bearing, the double-ring bearing includes a bearing inner ring and a bearing outer ring, and the bearing inner ring and the bearing outer ring is configured to perform relative rotational motion. The bearing inner ring is fixedly connected with the rotor, and the bearing outer ring is fixedly connected with the supporting component; or, the bearing outer ring is fixedly connected with the rotor, and the bearing inner ring is fixedly connected with the supporting component.

Optionally, the rotation decoupling component includes a connecting block, a first ball and second balls; the upper end of the connecting block is fixedly connected with the supporting component, the lower end of the connecting block is rotationally connected with the rotor through the first ball, and opposite surfaces of the connecting block and the rotor parallel to a rotation shaft are respectively configured with a groove adapted to the first ball, wherein at least one groove adapted to the first ball is an annular groove; and a plurality of second balls are located between the lower surface of the supporting component and the upper surface of the rotor to rotational connect the supporting component and the rotor, and the lower surface of the supporting component and the upper surface of the rotor are respectively configured with a groove adapted to the second ball, wherein at least one groove adapted to the second ball is an annular groove.

Optionally, the transfer device further includes a rotation constraint component, one end of the rotation constraint component is connected with the stator, the other end of the rotation constraint component is connected with the rotor, and when the supporting component performs rotational motion, the rotation constraint component limits the rotation of the rotor.

Optionally, the rotation constraint component includes a guide rail, the guide rail is located outside the vertical driving component to constrain the rotation of the rotor, the guide rail includes a guide rail fixing part and a guide rail vertical moving part adapted to the guide rail fixing part, the guide rail fixing part is fixedly connected with the stator, and the guide rail vertical moving part is fixedly connected with the rotor.

Optionally, the rotation constraint component includes a ball spline, the ball spline is located inside the vertical driving component to constrain the rotation of the rotor, the ball spline includes a shaft sleeve and a shaft lever adapted to the shaft sleeve, the shaft sleeve is fixedly connected with the stator, and the shaft lever is fixedly connected with the rotor.

Optionally, the rotating component further includes a rotating base and a top cover plate, wherein the rotating base is annularly disposed outside the vertical driving component, the supporting component and the rotation decoupling component and is connected with a rotor of the rotation driving component, a stator of the rotation driving component is connected with the base, the top cover plate is located above the rotating base and is connected with the rotating base, a first through hole passing through the top cover plate in a vertical direction is formed in the top cover plate, the carrying device is located above the top cover plate and is fixedly connected with the top cover plate, a second through hole passing through the carrying device in a vertical direction is formed in the carrying device, the position of the first through hole corresponds to the position of the second through hole in the vertical direction, and the supporting claws perform vertical motion in the first through hole and the second through hole, wherein when the rotation driving component drives the rotating base to rotate, the top cover plate, the carrying device and the supporting component are driven to rotate.

Optionally, the transfer device further includes a transmission component, the transmission component is located between the supporting component and the rotating component, and the transmission component drives the supporting component to perform synchronous rotational motion along with the carrying device and provides guidance for the lifting and lowering motion of the supporting component.

Optionally, the transmission component is located in the first through hole or the second through hole, the inner side of the transmission component is connected with the supporting claw, and the outer side of the transmission component is connected with the top cover plate or the carrying device.

Optionally, the transfer device further includes a flexible connector; the flexible connector is disposed in the second through hole, the outer side of the flexible connector is connected with the carrying device, and the inner side of the flexible connector is connected with the transmission component, wherein the inner side of the flexible connector is of an arc-shaped structure with a middle part protruding from upper and lower parts; or, the flexible connector is disposed in the first through hole, the outer side of the flexible connector is connected with the top cover plate, and the inner side of the flexible connector is connected with the transmission component, wherein the inner side of the flexible connector is of an arc-shaped structure with a middle part protruding from upper and lower parts.

Optionally, the transmission component is located between the outer side of the supporting component and the inner side of the rotating base, the outer side of the transmission component is connected with the inner side of the rotating base, and the inner side of the transmission component is connected with the outer side of the supporting component.

Optionally, the transfer device further includes a flexible connector, the flexible connector is disposed between the transmission component and the rotating base, the flexible connector includes a first part, a second part and a flexible deformation part connected with the first part and the second part respectively, the first part is connected with the transmission component, and the second part is connected with the rotating base.

Optionally, the top end of the supporting claw is configured with an adsorption head, a first gas path is formed in the supporting component, one end of the first gas path extends to the adsorption head, and the other end of the first gas path extends to the region of the rotation decoupling component; and a second gas path is formed inside the rotor, one end of the second gas path extends to the region of the rotation decoupling component and is communicated with the first gas path, and the other end of the second gas path is led out from the top of the side edge of the rotor and is connected with an exhaust device.

Optionally, the rotation decoupling component is configured with a clearance region, the first gas path and the second gas path are communicated in the clearance region and sealed with a sealing ring, and a connecting point between the first gas path and the second gas path is located on a rotation shaft of the supporting component; or,
the supporting component further includes an annular gas groove disposed in the clearance region, the annular gas groove is coaxial with the rotation shaft of the supporting component, and the first gas path and the second gas path are respectively communicated with the annular gas groove, wherein the second gas path is communicated with the annular gas groove and sealed with a sealing ring.

Optionally, a third gas path is formed in the region of the rotation decoupling component, the third gas path passes through the rotation decoupling component in a vertical direction, one end of the third gas path is communicated with the first gas path and sealed with a sealing ring, and the other end of the third gas path is communicated with the second gas path and sealed with a sealing ring; and the third gas path coincides with the rotation shaft of the supporting component, or the third gas path is an annular gas groove coaxial with the rotation shaft of the supporting component.

Optionally, the vertical driving component includes a voice coil motor, the voice coil motor includes a magnetic steel and a coil, the coil surrounds the magnetic steel. The coil constitutes the stator, and the magnetic steel constitutes the rotor; or the magnetic steel constitutes the stator, and the coil constitutes the rotor. Wherein, a magnetic block is disposed in the coil.

As mentioned above, in the transfer device of the present application, the rotational motion of the supporting component is decoupled from the vertical motion of the rotor, which can prevent gas pipes and routes located at the rotor part from rotating along with the supporting component, thereby solving the problems of winding and twisting of gas paths and cables, improving the system reliability, and prolonging the service life of the device. In addition, the supporting claws rotate along with the carrying device. Compared to an apparatus where supporting claws do not rotate along with the carrying device, the vertical motion stroke of the thickness of one carrying device can be shortened, thereby solving the problem of excessively long transfer stroke, and improving the transfer efficiency.

### Brief Description of the Drawings

The accompanying drawings of the specification, constituting a part of the present application, are used for providing a further understanding of the present application. The exemplary embodiments of the present application and the descriptions thereof are intended to explain the present application, but do not constitute an improper limitation on the present application. In the accompanying drawings:
Fig. 1 shows a schematic structural diagram of a transfer device provided in Embodiment 1 of the present application.
Fig. 2 shows a schematic structural diagram of a vertical driving component in Embodiment 1 of the present application.
Fig. 3 shows a schematic structural diagram of a first rotation decoupling component and components around the first rotation decoupling component in Embodiment 1 of the present application.
Fig. 4 shows a schematic structural diagram of a second rotation decoupling component and components around the second rotation decoupling component in Embodiment 1 of the present application.
Fig. 5 shows a schematic structural diagram of a first rotation constraint component in Embodiment 1 of the present application.
Fig. 6 shows a schematic structural diagram of a second rotation constraint component and components around the second rotation constraint component in Embodiment 1 of the present application.
Fig. 7 shows a schematic structural diagram of a transmission component in Embodiment 1 of the present application.
Fig. 8 shows a schematic structural diagram in which a first gas path and a second gas path are communicated in a clearance region in Embodiment 1 of the present application.
Fig. 9 shows a schematic structural diagram in which a first gas path and a second gas path are communicated through a third gas path in Embodiment 1 of the present application.
Fig. 10 shows a schematic structural diagram of a transfer device provided in Embodiment 2 of the present application.
Fig. 11 shows a three-dimensional schematic structural diagram in which a transmission component is mounted on a supporting component in Embodiment 2 of the present application.
Fig. 12 shows a three-dimensional schematic structural diagram in which a flexible connector is mounted on a transmission component in Embodiment 2 of the present application.
Fig. 13 shows a schematic structural diagram of a flexible connector in Embodiment 2 of the present application.

The above accompanying drawings have the following reference numerals:
1, base; 100, base bottom; 101, base side wall;
2, vertical driving component; 201, stator; 202, rotor; 203, mounting seat; 21, voice coil motor; 211, magnetic steel; 212, coil; 213, magnetic block; 214, back iron;
3, supporting component; 301, supporting claw; 302, adsorption head; 303, first gas path; 304, second gas path; 305, sealing ring; 306, third gas path;
4, rotation driving component; 5, carrying device;
6, rotation decoupling component; 601, double-ring bearing; 602, bearing inner mounting seat; 603, bearing outer mounting seat; 604, bearing inner pressure ring; 605, bearing outer pressure ring; 611, connecting block; 612, first ball; 613, second ball;
7, rotation constraint component; 70, guide rail; 701, guide rail fixing part; 702, guide rail vertical moving part; 71, ball spline; 711, shaft sleeve; 712, shaft lever;
8, rotating base; 9, top cover plate; 10, transmission component;
11, flexible connector; 1101, first part; 1102, second part; 1103, flexible deformation part;
12, rotation detection component; 13, vertical detection component; 14, elastic component; 15, outer bearing.

### Detailed Description of the Embodiments

The implementations of the present application are illustrated below through specific examples. Those skilled in the art can easily understand other advantages and effects of the present application according to the contents disclosed by the specification. The present application can also be implemented or applied through different specific implementations. Various details in the specification can also be modified or changed based on different perspectives and applications without departing from the spirit of the present application.

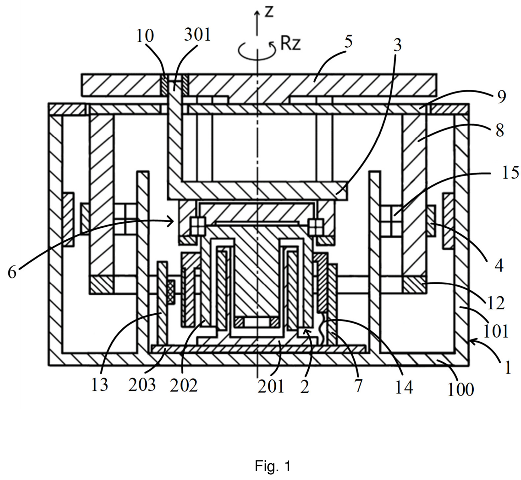

Refer to Fig. 1 to Fig. 13. It should be noted that the figures provided in these embodiments only illustrate the basic concept of the present application in a schematic manner. Therefore, the figures only show the components related to the present application and are not drawn according to the number, shape and size of the components in actual implementation. In actual implementation, the form, number and proportion of each component can be arbitrarily changed, and the layout of the component may also be more complex.

### Embodiment 1

This embodiment provides a transfer device. Referring to Fig. 1, the transfer device includes a base 1, a lifting and lowering component and a rotating component, wherein the base 1 includes a base bottom 100 and a base side wall 101, and the base bottom 100 and the base side wall 101 enclose an accommodating space; the lifting and lowering component includes a vertical driving component 2 located at the base bottom 100 and a supporting component 3 located above the vertical driving component 2, the vertical driving component 2 includes a stator 201 and a rotor 202, the stator 201 is mounted at the base bottom 100, and the rotor 202 is mounted on the stator 201 and can perform lifting and lowering motion relative to the stator 201; the upper end of the supporting component 3 is configured with a plurality of supporting claws 301; the rotating component includes a rotation driving component 4 located outside the supporting component 3 and a carrying device 5 located above the lifting and lowering component, the rotating component can rotate relative to the base 1, the rotation driving component 4 drives the supporting component 3 and the carrying device 5 to perform synchronous rotational motion, and the supporting component 3 can perform lifting and lowering motion relative to the carrying device 5; and the lifting and lowering component further includes a rotation decoupling component 6, the rotation decoupling component 6 is located between the vertical driving component 2 and the supporting component 3, and the vertical driving component 2 is rotationally connected with the supporting component 3 through the rotation decoupling component 6, so that when the supporting component 3 performs rotational motion, the vertical driving component 2 does not perform rotational motion along with the supporting component 3.

As an example, the base 1 is configured to mount each component and serve as a protective shell, the vertical driving component 2 further includes a mounting seat 203, and the mounting seat 203 is disposed between the stator 201 and the base bottom 100 and can be disassembled from the base 1 to facilitate maintenance and disassembly.

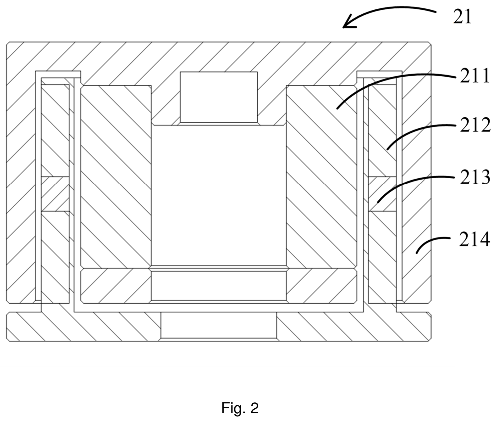

As an example, as shown in Fig. 2, the vertical driving component 2 includes a voice coil motor 21, and the voice coil motor 21 includes a magnetic steel 211 and a coil 212 surrounding the magnetic steel 211, wherein the magnetic steel 211 constitutes the rotor 202, and the coil 212 constitutes the stator 201. The coil 212 is energized to generate the same or different magnetic properties as the magnetic steel 211 to drive the magnetic steel 211 to move up and down, thereby driving the rotation decoupling component 6 and the supporting component 3 to move up and down. Preferably, the voice coil motor 21 adopts a magnetic levitation integrated voice coil motor with gravity compensation, and a magnetic block 213 is added in the middle of the coil 212 to achieve a magnetic levitation function to achieve the effect of gravity compensation, so that the output force of the voice coil motor 21 is more uniform, thereby making the motion of the supporting component 3 more stable. Furthermore, the output force of the voice coil motor 21 is reduced, and the working current of the voice coil motor 21 can also be reduced, thereby reducing the generated heat. The outer side of the coil 212 is configured with back iron 214. In other examples, the magnetic steel 211 may constitute the stator 201 and the coil 212 may constitute the rotor 202, which is not limited in this embodiment. It should be noted that in this embodiment, to balance the output force and motion accuracy, the voice coil motor 21 is selected as the vertical driving component 2. In other cases, different motors, such as a planar motor or a stepping motor, may be selected as vertical driving components, which are not limited here.

As an example, the rotation driving component 4 includes a torque motor, the torque motor includes a motor stator and a motor rotor, the motor stator is connected with the base 1, and the motor rotor is configured to drive the carrying device 5 and the supporting component 3 to rotate. In other examples, the rotation driving component 4 may be another rotating motor, which is not limited in this embodiment.

As an example, the carrying device 5 includes a suction cup for adsorbing a wafer.

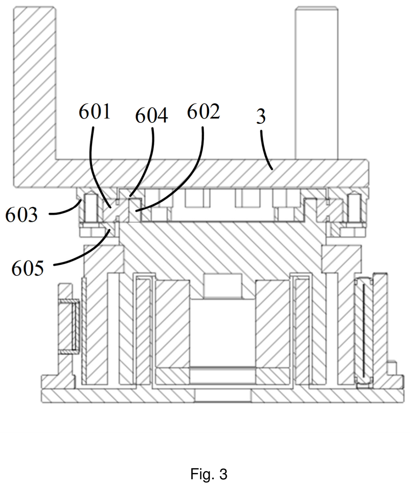

As an example, as shown in Fig. 3, the rotation decoupling component 6 includes a double-ring bearing 601. The double-ring bearing 601 includes a bearing inner ring and a bearing outer ring, and the bearing inner ring and the bearing outer ring can perform relative rotational motion. The bearing inner ring is fixedly connected with the rotor 202, and the bearing outer ring is fixedly connected with the supporting component 3. The rotation decoupling component 6 further includes a bearing inner mounting seat 602, a bearing outer mounting seat 603, a bearing inner pressure ring 604 and a bearing outer pressure ring 605. The bearing inner mounting seat 602 is located inside the double-ring bearing 601, and the bearing inner pressure ring 604 is configured to connect the bearing inner ring with the bearing inner mounting seat 602 in the manner of press fit. The bearing outer mounting seat 603 is located outside the double-ring bearing 601, and the bearing outer pressure ring 605 is configured to connect the bearing outer ring with the bearing outer mounting seat 603 in the manner of press fit. The bearing inner mounting seat 602 is connected with the rotor 202, and the bearing outer mounting seat 603 is connected with the supporting component 3. In other examples, the bearing inner ring may be fixedly connected with the supporting component 3 and the bearing outer ring may be fixedly connected with the rotor 202, which is not limited in this embodiment. The rotation decoupling component 6 is configured to decouple the supporting component 3 from the vertical driving component 2 during rotation of the supporting component 3, that is, the vertical driving component 2 does not rotate along with the supporting component 3.

As an example, the vertical driving component 2 does not rotate along with the supporting component 3, so that on the one hand, the winding and twisting of gas paths and cables can be avoided; and on the other hand, the driving quality of the rotation driving component 4 can be reduced, and the rotation accuracy can be improved.

As an example, further, the rotor 202 of the vertical driving component 2 may be used as the bearing inner mounting seat 602 to simplify the structure so as to make the structure compact. Similarly, the supporting component 3 may also be used as the bearing outer mounting seat 603.

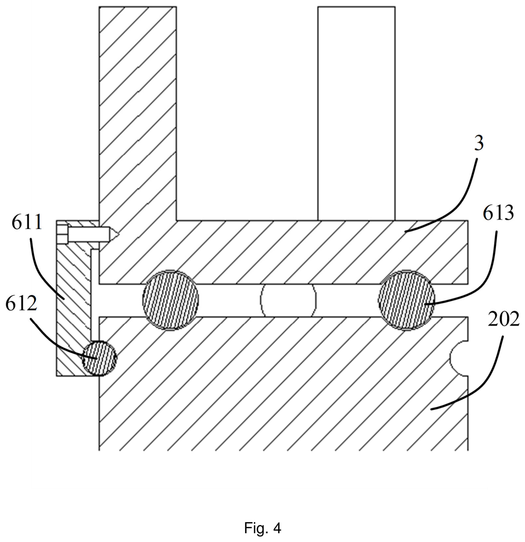

As an example, Fig. 4 shows another schematic structural diagram of a rotation decoupling component 6, including a connecting block 611, a first ball 612 and second balls 613. The upper end of the connecting block 611 is fixedly connected with the supporting component 3, the lower end of the connecting block 611 is rotationally connected with the rotor 202 through the first ball 612, and opposite surfaces of the connecting block 611 and the rotor 202 parallel to a rotation shaft are respectively configured with a groove adapted to the first ball 612, wherein at least one groove adapted to the first ball 612 is an annular groove. A plurality of second balls 613 are located between the lower surface of the supporting component 3 and the upper surface of the rotor 202 so that the supporting component 3 is rotationally connected with the rotor 202, and the lower surface of the supporting component 3 and the upper surface of the rotor 202 are respectively configured with a groove adapted to the second ball 613, wherein at least one groove adapted to the second ball 613 is an annular groove. Preferably, the inner side surface of the connecting block 611 and the outer side surface of the rotor 202 are disposed oppositely, that is, the connecting block 611 is disposed outside the rotor 202, wherein the grooves on the rotor 202, opposite to the first ball 612 and the second ball 613, are both annular grooves.

As an example, the transfer device further includes a rotation constraint component 7. One end of the rotation constraint component 7 is connected with the stator 201, and the other end of the rotation constraint component 7 is connected with the rotor 202. When the supporting component 3 performs rotational motion, the rotation constraint component 7 limits the rotation of the rotor 202.

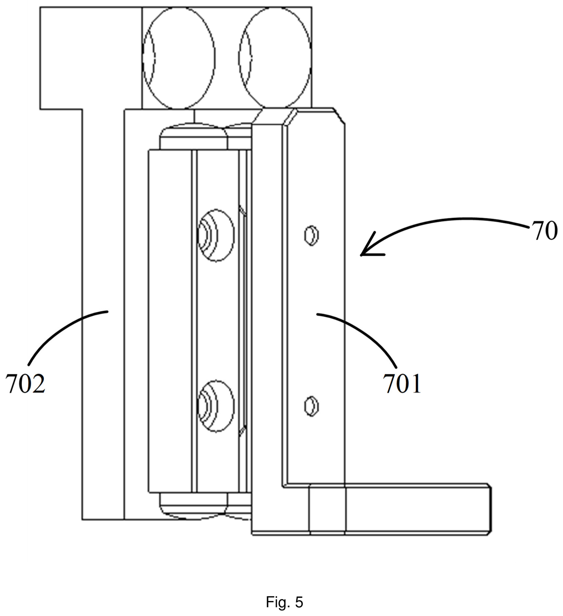

As an example, as shown in Fig. 5, the rotation constraint component 7 includes a guide rail 70. The guide rail 70 is located outside the vertical driving component 2 to constrain the rotation of the rotor 202. The guide rail 70 includes a guide rail fixing part 701 and a guide rail vertical moving part 702 adapted to the guide rail fixing part 701. The guide rail fixing part 701 is fixedly connected with the stator 201, and the guide rail vertical moving part 702 is fixedly connected with the rotor 202. The rotation constraint component 7 can not only limit the rotation of the rotor 202, but also provide vertical motion guidance for the rotor 202. Preferably, the guide rail 70 adopts a cross ball guide rail, that is, cross balls are disposed between the guide rail fixing part 701 and the guide rail vertical moving part 702 to reduce the motion friction between the guide rail fixing part 701 and the guide rail vertical moving part 702, thereby improving the vertical motion accuracy.

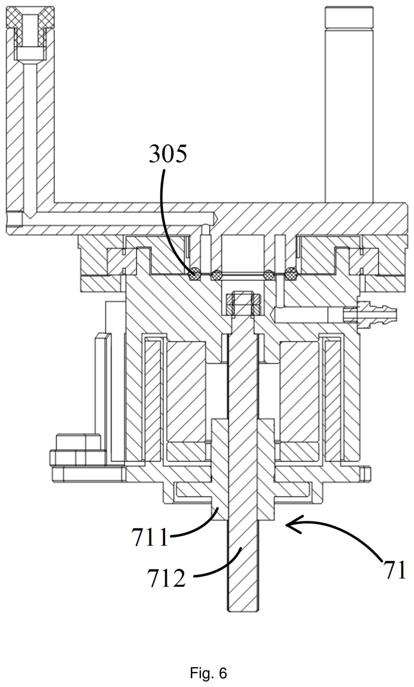

As an example, Fig. 6 shows another schematic structural diagram of a rotation constraint component 7, including a ball spline 71. The ball spline 71 is located inside the vertical driving component 2 to constrain the rotation of the rotor 202. The ball spline 71 includes a shaft sleeve 711 and a shaft lever 712. The shaft sleeve 711 is fixedly connected with the stator 201, and the shaft lever 712 is fixedly connected with the rotor 202. In an example, a square slide way is disposed in the shaft sleeve 711, and the shaft lever 712 is a square shaft lever adapted to the square slide way. In another example, a circular slide way is disposed in the shaft sleeve 711, and the shaft lever 712 is a circular shaft lever adapted to the circular slide way, wherein a limiting groove is formed in the circular slide way so that the shaft lever 712 can only perform lifting and lowering motion in a vertical direction and cannot rotate in a horizontal direction.

As an example, the rotating component further includes a rotating base 8 and a top cover plate 9, wherein the rotating base 8 is annularly disposed outside the vertical driving component 2, the supporting component 3 and the rotation decoupling component 6 and is connected with the rotor of the rotation driving component 4, the stator of the rotation driving component 4 is connected with the base 1, the top cover plate 9 is located above the rotating base 8 and is connected with the rotating base 8, a first through hole passing through the top cover plate 9 in a vertical direction is formed in the top cover plate 9, the carrying device 5 is located above the top cover plate 9 and is fixedly connected with the top cover plate 9, a second through hole passing through the carrying device 5 in a vertical direction is formed in the carrying device 5, the position of the first through hole corresponds to the position of the second through hole in the vertical direction, and the supporting claws 301 perform vertical motion in the first through hole and the second through hole, wherein when the rotation driving component 4 drives the rotating base 8 to rotate, the top cover plate 9, the carrying device 5 and the supporting component 3 are driven to rotate.

As an example, the transfer device further includes a transmission component 10, the transmission component 10 is located in the second through hole, the transmission component 10 includes a linear bearing, the inner side of the transmission component 10 is connected with the supporting claw 301, and the outer side of the transmission component 10 is connected with the carrying device 5. On the one hand, the transmission component 10 fixes the relative positions of the supporting component 3 and the carrying device 5 to better drive the supporting component 3 to synchronously rotate along with the carrying device 5. On the other hand, the transmission component 10 can provide guidance for the lifting and lowering motion of the supporting component 3. In another example, the transmission component 10 is located in the first through hole, the inner side of the transmission component 10 is connected with the supporting claw 301, and the outer side of the transmission component 10 is connected with the top cover plate 9.

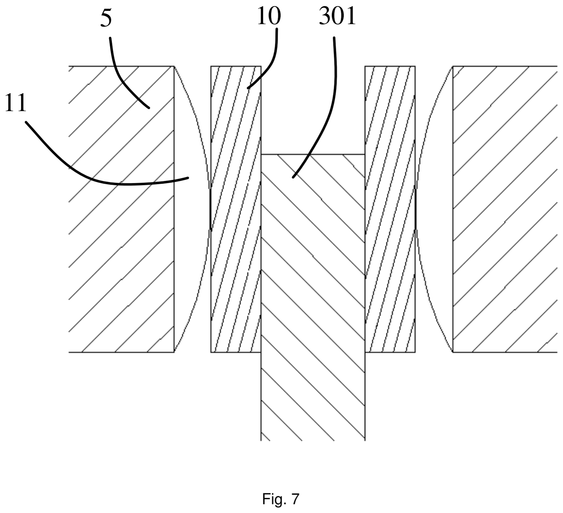

As an example, both the rotation constraint component 7 and the transmission component 10 have a vertical guiding effect, so there is a problem of over-constraint, which affects the stability of motion and the service life of structural components. The transfer device further includes a flexible connector 11. As shown in Fig. 7, the flexible connector 11 is disposed in the second through hole, the outer side of the flexible connector 11 is connected with the carrying device 5, and the inner side of the flexible connector 11 is connected with the transmission component 10, wherein the inner side of the flexible connector 11 is of an arc-shaped structure with a middle part protruding from upper and lower parts. When the rotation constraint component 7 and the transmission component 10 are over-constrained, the transmission component 10 can tilt to solve the problem of over-constraint. In another example, when the transmission component 10 is located in the first through hole, the flexible connector 11 is disposed in the first through hole, the outer side of the flexible connector 11 is connected with the top cover plate 9, and the inner side of the flexible connector 11 is connected with the transmission component 10.

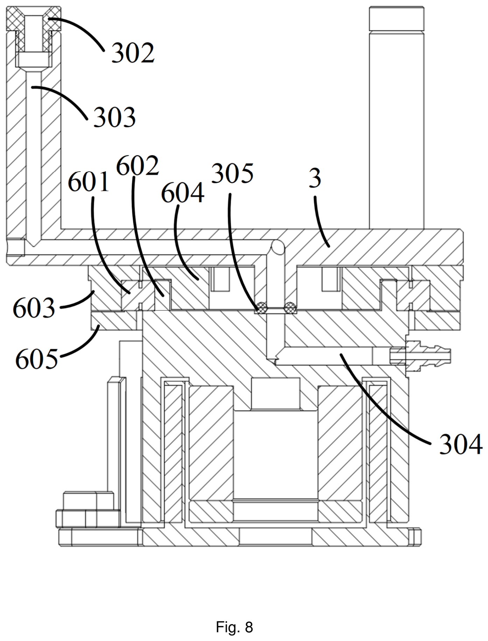

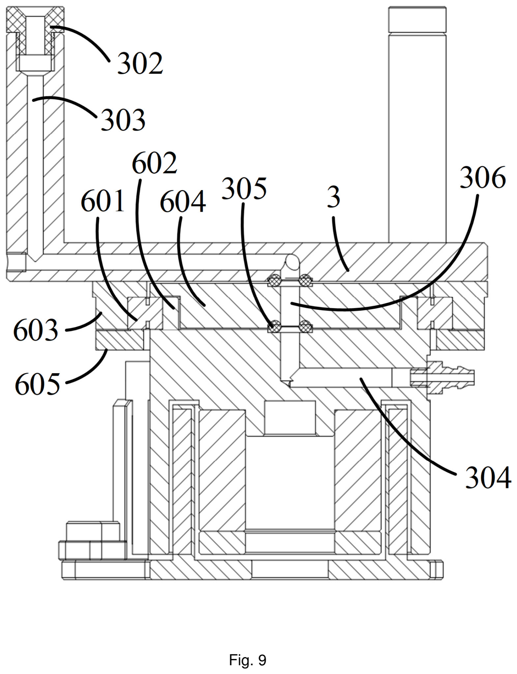

As an example, as shown in Fig. 8, the top end of the supporting claw 301 is configured with an adsorption head 302. A first gas path 303 is formed in the supporting component 3. One end of the first gas path 303 extends to the adsorption head 302 and is communicated with the adsorption head 302, and the other end of the first gas path 303 extends to the region of the rotation decoupling component 6. A second gas path 304 is formed inside the rotor 202. One end of the second gas path 304 extends to the region of the rotation decoupling component 6 and is communicated with the first gas path 303. The rotation decoupling component 6 is configured with a clearance region. The first gas path 303 and the second gas path 304 are communicated in the clearance region and sealed with a sealing ring 305. A connecting point between the two gas paths is located on the rotation shaft of the supporting component 3, that is, the position of the connecting point cannot be changed due to the rotation of the supporting component 3. The other end of the second gas path 304 is led out from the top of the side edge of the rotor 202 and is connected with an exhaust device. Certainly, referring to Fig. 6, an annular gas groove coaxial with the rotation shaft of the supporting component 3 may also be disposed in the clearance region, the first gas path 303 and the second gas path 304 are respectively communicated with the annular gas groove, and the second gas path 304 is communicated with the annular gas groove and sealed with a sealing ring 305. In an example, as shown in Fig. 9, the rotation decoupling component 6 is not configured with a clearance region, a third gas path 306 is formed in the region of the rotation decoupling component 6, and the third gas path 306 passes through the region of the rotation decoupling component 6 in a vertical direction. One end of the third gas path 306 is communicated with the first gas path 303 and sealed with a sealing ring 305, and the other end of the third gas path 306 is communicated with the second gas path 304 and sealed with a sealing ring 305. The third gas path 306 coincides with the rotation shaft of the supporting component 3, or the third gas path 306 is an annular gas groove coaxial with the rotation shaft of the supporting component 3.

As an example, the transfer device further includes a rotation detection component 12, and the rotation detection component 12 is located at the bottom of the rotating base 8 and configured to detect rotation position information.

As an example, the transfer device further includes a vertical detection component 13, the vertical detection component 13 includes a tape part and a read head part, the tape part is fixedly connected with the rotor 202, and both the read head part and the stator 201 are fixedly connected to a same bottom plate, and the read head part is configured to detect lifting and lowering position information.

As an example, the transfer device further includes an elastic component 14, the elastic component 14 is disposed along a vertical direction, one end of the elastic component 14 is fixedly connected with the stator 201, and the other end of the elastic component 14 is fixedly connected with the rotor 202. When the vertical driving component 2 is powered off, the supporting component 3 can restore to the initial position under the elastic action of the elastic component 14 for vertical motion resetting. The elastic component 14 includes a tension spring.

As an example, the transfer device further includes an outer bearing 15, the outer bearing 15 is located on the inner side of the rotating base 8, the inner ring of the outer bearing 15 is fixedly connected with the base 1, and the outer ring of the outer bearing 15 is rotationally connected with the inner side of the rotating base 8 to provide rotation guidance for the rotating base 8.

As an example, the transfer device is further configured with an electrical limiting component and a mechanical limiting component which are respectively used for electrical safety limiting up and down and mechanical safety limiting up and down during vertical motion of the supporting component 3.

In the transfer device of this embodiment, when the rotation driving component 4 drives the rotating component to rotate around a central axis, the part of the rotation decoupling component 6 (bearing outer ring) connected with the supporting component 3 also synchronously rotates. The rotation constraint component 7 limits the rotation of the rotor 202 relative to the stator 201, and the rotor 202 and the part of the rotation decoupling component 6 (bearing inner ring) fixedly connected to the rotor 202 remain stationary to decouple the rotational motion of the supporting component 3 from the vertical motion of the rotor 202, so as to prevent gas pipes and routes located at the part of the rotor 202 from rotating along with the supporting component 3, thereby solving the problems of winding and twisting of gas paths and cables, improving the system reliability, and prolonging the service life of the device. Moreover, the supporting claws 301 rotate along with the carrying device 5. Compared to an apparatus where supporting claws do not rotate along with the carrying device 5, the vertical motion stroke of the thickness of one carrying device 5 can be shortened, thereby solving the problem of excessively long transfer stroke, and improving the transfer efficiency.

### Embodiment 2

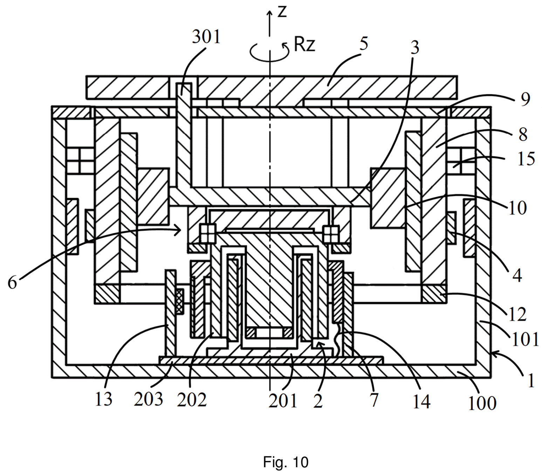

This embodiment provides a transfer device. Referring to Fig. 10, the main differences between the transfer device in this embodiment and the transfer device in Embodiment 1 are: the transmission component 10 is located between the outer side of the supporting component 3 and the inner side of the rotating base 8, the outer side of the transmission component 10 is connected with the inner side of the rotating base 8, and the inner side of the transmission component 10 is connected with the outer side of the supporting component 3.

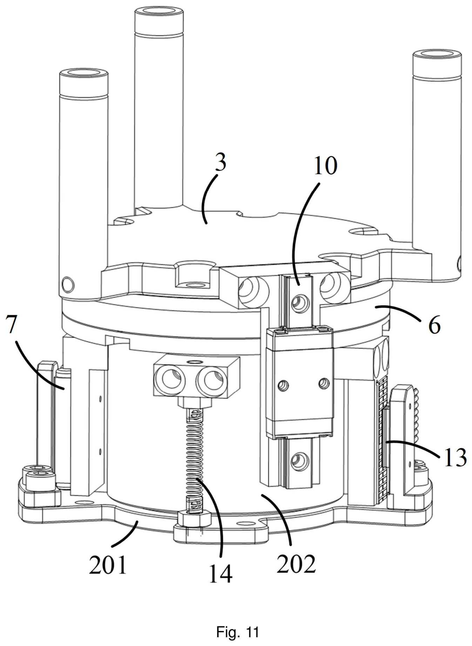

As an example, the transmission component 10 includes a linear bearing, or a guide rail slide block, or the like. As shown in Fig. 11, in this embodiment, the transmission component 10 adopts a guide rail slide block, a slide way fixing part is fixedly connected with the rotating base 8, a slide block moving part is fixedly connected with the supporting component 3, the transmission component 10 provides guidance for vertical motion of the supporting component 3, and simultaneously, the transmission component 10 fixes the relative positions of the supporting component 3 and the carrying device 5. When the rotating component is driven by the rotation driving component 4 to perform rotational motion, the supporting component 3 and the carrying device 5 can be better driven to synchronously rotate.

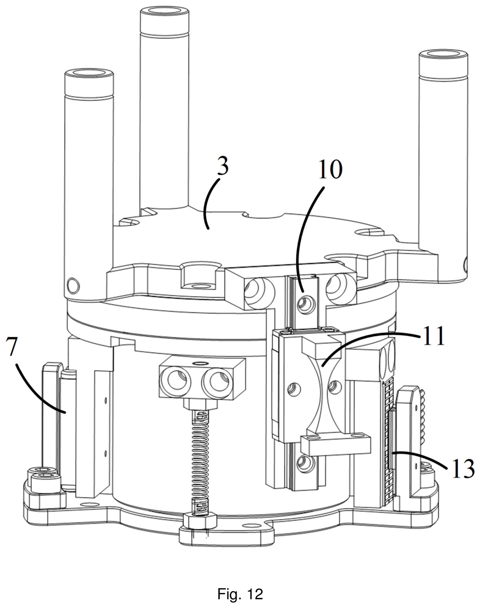

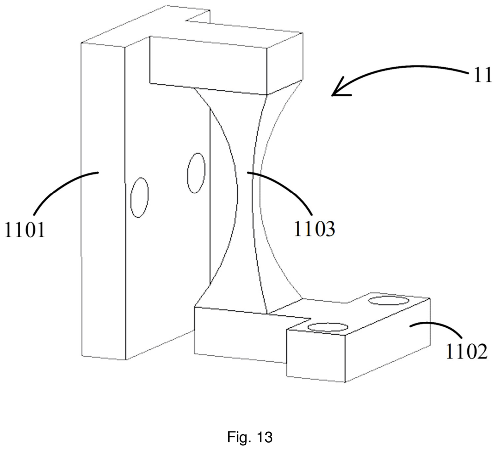

As an example, in this embodiment, the flexible connector 11 is disposed between the transmission component 10 and the rotating base 8. Fig. 12 shows a schematic structural diagram in which the flexible connector 11 is mounted on the transmission component 10. Fig. 13 shows a schematic structural diagram of a flexible connector 11, including a first part 1101, a second part 1102 and a flexible deformation part 1103 connected with the first part 1101 and the second part 1102 respectively, wherein the first part 1101 includes a longitudinal support plate and a transverse support plate which is located at the top end of the longitudinal support plate and protrudes from the longitudinal support plate along one side away from the transmission component 10, the longitudinal support plate is configured with a mounting hole for connecting with the transmission component 10, the second part 1102 includes a "T"-shaped transverse plate, the "T"-shaped transverse plate is configured with a mounting hole for connecting with the rotating base 8, the transverse support plate of the first part 1101 is parallel to the "T"-shaped transverse plate of the second part 1102, the flexible deformation part 1103 has an "hourglass" shape with cross sections of upper and lower ends larger than a middle part, the flexible deformation part 1103 is located between the transverse support plate of the first part 1101 and the "T"-shaped transverse plate of the second part 1102, and two ends of the flexible deformation part 1103 are respectively connected with the transverse support plate of the first part 1101 and the "T"-shaped transverse plate of the second part 1102. When the rotation constraint component 7 and the transmission component 10 are over-constrained, the flexible deformation part 1103 of the flexible connector 11 can deform to solve the problem of over-constraint.

As an example, the outer bearing 15 is located on the outer side of the rotating base 8, the outer ring of the outer bearing 15 is fixedly connected with the base 1, and the inner ring of the outer bearing 15 is rotationally connected with the outer side of the rotating base 8 to provide rotation guidance for the rotating base 8.

As mentioned above, in the transfer device of the present application, the rotational motion of the supporting component is decoupled from the vertical motion of the rotor, which can prevent gas pipes and routes located at the rotor part from rotating along with the supporting component, thereby solving the problems of winding and twisting of gas paths and cables, improving the system reliability, and prolonging the service life of the device. In addition, supporting claws rotate along with the carrying device. Compared to an apparatus where supporting claws do not rotate along with the carrying device, the vertical motion stroke of the thickness of one carrying device can be shortened, thereby solving the problem of excessively long transfer stroke, and improving the transfer efficiency. Therefore, the present application effectively overcomes various defects in the prior art and has high industrial utilization value.

The above embodiments merely illustrate the principles and effects of the present application, and are not intended to limit the present application. Anyone familiar with this technology can modify or change the above embodiments without departing from the spirit and scope of the present application. Therefore, all equivalent modifications or changes made by those skilled in the art without departing from the spirit and technical idea disclosed in the present application still should be covered by the claims of the present application.

## Claims

1. A transfer device, comprising:
a base (1), comprising a base bottom (100) and a base side wall (101), wherein the base bottom (100) and the base side wall (101) enclose an accommodating space;
a lifting and lowering component, comprising a vertical driving component (2) located at the base bottom (100) and a supporting component (3) located above the vertical driving component (2), wherein the vertical driving component (2) comprises a stator (201) and a rotor (202), the stator (201) is mounted at the base bottom (100), and the rotor (202) is mounted on the stator (201) and configured for vertical motion relative to the stator (201); and the supporting component (3) performs lifting and lowering motion along with the rotor (202), and an upper end of the supporting component (3) is configured with a plurality of supporting claws (301); and
a rotating component, comprising a rotation driving component (4) located outside the supporting component (3) and a carrying device (5) located above the lifting and lowering component, wherein the rotating component is configured to rotate relative to the base (1), the rotation driving component (4) drives the supporting component (3) and the carrying device (5) to perform synchronous rotational motion, and the supporting component (3) is configured for lifting and lowering motion relative to the carrying device (5); and
the lifting and lowering component further comprises a rotation decoupling component (6), wherein the rotation decoupling component (6) is located between the vertical driving component (2) and the supporting component (3), and the vertical driving component (2) is rotationally connected with the supporting component (3) through the rotation decoupling component (6), when the supporting component (3) performs rotational motion, the vertical driving component (2) does not perform rotational motion along with the supporting component (3).

2. The transfer device according to claim 1, wherein the rotation decoupling component (6) comprises a double-ring bearing (601), the double-ring bearing (601) comprises a bearing inner ring and a bearing outer ring, and the bearing inner ring and the bearing outer ring is configured to perform relative rotational motion;
the bearing inner ring is fixedly connected with the rotor (202), and the bearing outer ring is fixedly connected with the supporting component (3); or
the bearing outer ring is fixedly connected with the rotor (202), and the bearing inner ring is fixedly connected with the supporting component (3).

3. The transfer device according to claim 1, wherein the rotation decoupling component (6) comprises a connecting block (611), a first ball (612) and second balls (613), an upper end of the connecting block (611) is fixedly connected with the supporting component (3), a lower end of the connecting block (611) is rotationally connected with the rotor (202) through the first ball (612), and opposite surfaces of the connecting block (611) and the rotor (202) parallel to a rotation shaft are respectively configured with a groove adapted to the first ball (612), wherein at least one groove adapted to the first ball (612) is an annular groove; and a plurality of second balls (613) are located between a lower surface of the supporting component (3) and an upper surface of the rotor (202) to rotational connect the supporting component (3) and the rotor (202), and the lower surface of the supporting component (3) and the upper surface of the rotor (202) are respectively configured with a groove adapted to the second ball (613), wherein at least one groove adapted to the second ball (613) is an annular groove.

4. The transfer device according to claim 1, wherein the transfer device further comprises a rotation constraint component (7), one end of the rotation constraint component (7) is connected with the stator (201), the other end of the rotation constraint component (7) is connected with the rotor (202), and when the supporting component (3) performs rotational motion, the rotation constraint component (7) limits the rotation of the rotor (202).

5. The transfer device according to claim 4, wherein the rotation constraint component (7) comprises a guide rail (70), the guide rail (70) is located outside the vertical driving component (2) to constrain the rotation of the rotor (202), the guide rail (70) comprises a guide rail fixing part (701) and a guide rail vertical moving part (702) adapted to the guide rail fixing part (701), the guide rail fixing part (701) is fixedly connected with the stator (201), and the guide rail vertical moving part (702) is fixedly connected with the rotor (202).

6. The transfer device according to claim 4, wherein the rotation constraint component (7) comprises a ball spline (71), the ball spline (71) is located inside the vertical driving component (2) to constrain the rotation of the rotor (202), the ball spline (71) comprises a shaft sleeve (711) and a shaft lever (712) adapted to the shaft sleeve (711), the shaft sleeve (711) is fixedly connected with the stator (201), and the shaft lever (712) is fixedly connected with the rotor (202).

7. The transfer device according to claim 1, wherein the rotating component further comprises a rotating base (8) and a top cover plate (9), wherein the rotating base (8) is annularly disposed outside the vertical driving component (2), the supporting component (3) and the rotation decoupling component (6) and is connected with a rotor of the rotation driving component (4), a stator of the rotation driving component (4) is connected with the base (1), the top cover plate (9) is located above the rotating base (8) and is connected with the rotating base (8), a first through hole passing through the top cover plate (9) in a vertical direction is formed in the top cover plate (9), the carrying device (5) is located above the top cover plate (9) and is fixedly connected with the top cover plate (9), a second through hole passing through the carrying device (5) in a vertical direction is formed in the carrying device (5), a position of the first through hole corresponds to a position of the second through hole in the vertical direction, and the supporting claws (301) perform vertical motion in the first through hole and the second through hole, wherein when the rotation driving component (4) drives the rotating base (8) to rotate, the top cover plate (9), the carrying device (5) and the supporting component (3) are driven to rotate.

8. The transfer device according to claim 7, wherein the transfer device further comprises a transmission component (10), the transmission component (10) is located between the supporting component (3) and the rotating component, and the transmission component (10) drives the supporting component (3) to perform synchronous rotational motion along with the carrying device (5) and provides guidance for the lifting and lowering motion of the supporting component (3).

9. The transfer device according to claim 8, wherein the transmission component (10) is located in the first through hole or the second through hole, an inner side of the transmission component (10) is connected with the supporting claw (301), and an outer side of the transmission component (10) is connected with the top cover plate (9) or the carrying device (5).

10. The transfer device according to claim 9, wherein the transfer device further comprises a flexible connector (11);
the flexible connector (11) is disposed in the second through hole, an outer side of the flexible connector (11) is connected with the carrying device (5), and an inner side of the flexible connector (11) is connected with the transmission component (10), wherein the inner side of the flexible connector (11) is of an arc-shaped structure with a middle part protruding from upper and lower parts; or
the flexible connector (11) is disposed in the first through hole, an outer side of the flexible connector (11) is connected with the top cover plate (9), and an inner side of the flexible connector (11) is connected with the transmission component (10), wherein the inner side of the flexible connector (11) is of an arc-shaped structure with a middle part protruding from upper and lower parts.

11. The transfer device according to claim 8, wherein the transmission component (10) is located between an outer side of the supporting component (3) and an inner side of the rotating base (8), an outer side of the transmission component (10) is connected with the inner side of the rotating base (8), and an inner side of the transmission component (10) is connected with the outer side of the supporting component (3).

12. The transfer device according to claim 11, wherein the transfer device further comprises a flexible connector (11), the flexible connector (11) is disposed between the transmission component (10) and the rotating base (8), the flexible connector (11) comprises a first part (1101), a second part (1102) and a flexible deformation part (1103) connected with the first part (1101) and the second part (1102) respectively, the first part (1101) is connected with the transmission component (10), and the second part (1102) is connected with the rotating base (8).

13. The transfer device according to claim 1, wherein a top end of the supporting claw (301) is configured with an adsorption head (302), a first gas path (303) is formed in the supporting component (3), one end of the first gas path (303) extends to the adsorption head (302), and the other end of the first gas path (303) extends to a region of the rotation decoupling component (6); and a second gas path (304) is formed inside the rotor (202), one end of the second gas path (304) extends to the region of the rotation decoupling component (6) and is communicated with the first gas path (303), and the other end of the second gas path (304) is led out from a top of a side edge of the rotor (202) and is connected with an exhaust device.

14. The transfer device according to claim 13, wherein
the rotation decoupling component (6) is configured with a clearance region, the first gas path (303) and the second gas path (304) are communicated in the clearance region and sealed with a sealing ring (305), and a connecting point between the first gas path (303) and the second gas path (304) is located on a rotation shaft of the supporting component (3); or
the supporting component (3) further comprises an annular gas groove disposed in a clearance region, the annular gas groove is coaxial with a rotation shaft of the supporting component (3), and the first gas path (303) and the second gas path (304) are respectively communicated with the annular gas groove, wherein the second gas path (304) is communicated with the annular gas groove and sealed with a sealing ring (305).

15. The transfer device according to claim 13, wherein a third gas path (306) is formed in the region of the rotation decoupling component (6), the third gas path (306) passes through the rotation decoupling component (6) in a vertical direction, one end of the third gas path (306) is communicated with the first gas path (303) and sealed with a sealing ring (305), and the other end of the third gas path (306) is communicated with the second gas path (304) and sealed with a sealing ring (305); and
the third gas path (306) coincides with a rotation shaft of the supporting component (3); or, the third gas path (306) is an annular gas groove coaxial with a rotation shaft of the supporting component (3).

16. The transfer device according to claim 1, wherein the vertical driving component (2) comprises a voice coil motor (21), the voice coil motor (21) comprises a magnetic steel (211) and a coil (212), the coil (212) surrounds the magnetic steel (211), and a magnetic block (213) is disposed in the coil (212);
the coil (212) constitutes the stator (201), and the magnetic steel (211) constitutes the rotor (202); or
the magnetic steel (211) constitutes the stator (201), and the coil (212) constitutes the rotor (202).
